# EUROPÄISCHE PATENTSCHRIFT

(11) **EP 0 563 605 B1**
(45) Veröffentlichungstag und Bekanntmachung des Hinweises auf die Patenterteilung: **18.10.1995**
(21) Anmeldenummer: 93103431.8
(22) Anmeldetag: 03.03.1993
(51) Int. Cl.: B29C 59/16, B29C 71/04, B01D 67/00, C08J 7/12

(54) **Verfahren zum Erzeugen von Mikrostrukturen**
Method for the production of microstructures
Procédé pour obtenir des microstructures

(30) Priorität: 31.03.1992 DE 4210486
(43) Veröffentlichungstag der Anmeldung: 06.10.1993
(73) Patentinhaber: Gesellschaft für Schwerionenforschung mbH, D-64291 Darmstadt (DE)
(72) Erfinder: Trautmann, Christine, W-6100 Darmstadt (DE); Spohr, Reimar, Dr., W-6100 Darmstadt (DE); Angert, Norbert, W-6101 Weiterstadt-Braunshardt (DE); Brüchle, Willy, W-6101 Weiterstadt 1 (DE); Vetter, Johann, W-6100 Darmstadt (DE)
(74) Vertreter: Rückert, Friedrich, Dr.

(56) Entgegenhaltungen:
- EP-A- 0 331 090
- EP-A- 0 364 628
- DE-A- 2 140 579
- DE-A- 3 816 078
- FR-A- 1 357 143
- US-A- 3 713 921
- US-A- 3 802 972
- US-A- 3 852 134
- US-A- 4 039 371
- US-A- 4 648 950
- DATABASE WPIL Week 9303, Derwent Publications Ltd., London, GB; AN 93-026182 & SU-A-1716458 (EREV. PHSY. INST.) 29. Februar 1992

## Beschreibung

Die vorliegende Erfindung betrifft ein Verfahren zum Erzeugen von Mikrostrukturen wie Mikrolöchern oder -kanälen in isolierenden Festkörpern, vorzugsweise aus Polyimid durch Bestrahlen des Festkörpers mit Ionen vorbestimmter Kernladungszahl, Dichte und Energie, mit anschliessendem Reifen der Teilchenspuren durch Oxidationsprozesse und darauf folgendem Ätzen der gereiften Teilchenspuren in wässriger Ätzlösung.

Zur Ätzung von Teilchen bzw. Kernspuren energiereicher schwerer Ionen in Polyimid wurde bisher eine wässrige Lösung von Natriumhypochlorit im Temperaturbereich zwischen 50 und 80° C eingesetzt. Dabei waren die Selektivität und die Reproduzierbarkeit des Verfahrens zum technischen Einsatz nicht immer zufriedenstellend. Die Selektivität S der Teilchenspurätzung mit einer an der bestrahlten Oberfläche angreifenden Ätzflüssigkeit ist definiert als das Verhältnis der Spurätzrate V_{T} zur Ätzrate V_{B} des ungestörten Materiales. Unter der Spurätzrate V_{T} versteht man die Ätzrate entlang einer Teilchenspur und unter der Materialätzrate V_{B} die Ätzrate im Material quer zu der Spur. Beide Ätzraten überlagern sich. Bei hoher Selektivität S, d.h. einem hohen Wert von V_{T} gegenüber V_{B} entsteht durch die entlang der Teilchenspur schneller voranschreitende Ätzung ein schlanker Ätzkegel. Im umgekehrten Fall ensteht bei niederer Selektivität S ein stumpfer Ätzkegel, da sich der Ätzprozess infolge des höheren V_{B} in Querrichtung zur Spur schneller ausbreitet.

Die Selektivität der Ätzung von Teilchenspuren bei einem Polyimid bestimmter Art war nicht immer ausreichend zur Herstellung parallelwandiger Kanäle. Auch die Reproduzierbarkeit der Ätzung war bei dem Material nicht immer zufriedenstellend. In einigen Chargen traten schlanke Ätzkegel auf und in anderen stumpfe. Dabei streute der Durchmesser der Teilchenspuren erheblich. Eine einheitliche Lochgröße war nicht zu erzielen.

Diese einheitliche Lochgröße ist jedoch eine unbedingte Voraussetzung zur Herstellung von Mikrostrukturen wie z.B. von Filtern hoher Selektivität.

Bei der Herstellung bekannter Mikrostrukturen wie kommerzieller Teilchenspurfilter werden als Ausgangsmaterial Polymerfolien eingesetzt. Das Herstellungsverfahren umfaßt bei einem bekannten Verfahren die folgenden Schritte:
1. Durchstrahlung mit Spaltfragmenten bzw. mit schweren Ionen bekannter Energie.
2. Lagerung unter atmosphärischen Bedingungen an Luft. Dadurch reagieren die entlang der Ionenbahn im Polymer gebildeten chemischen Radikale zum Teil mit Luftsauerstoff. Das Ausheilen der Kettenbrüche wird unterbunden und die nachfolgende selektive Ätzung ermöglicht.
3. Durch naßchemisches Ätzen in einem geeigneten Medium werden Kettenbruchstücke zunächst herausgelöst bis anschließend die Teilchenspur im gleichen Ätzmedium auf den gewünschten Spurdurchmesser aufgeätzt ist.

Die bisherige Technik kennt damit nur ein einziges naßchemisches Verfahren, bei dem dasselbe Ätzmedium gleichzeitig die latente Teilchenspur aus dem Festkörper herauslöst und die Teilchenspur auf den gewünschten Durchmesser bringt. Daraus ergibt sich das Problem, gleichzeitig zwei diametral verschiedene Qualitätsmerkmale optimieren zu müssen:
Die Erhöhung der Selektivität ist infolge der eingangs beschriebenen Zusammenhänge gleichbedeutend mit einer Herabsetzung der Ätzrate des ungestörten Materiales. Dadurch erhöht sich jedoch die Verweildauer im Ätzbad. Gleichzeitig tritt in vielen Fällen aufgrund geringfügiger Materialinhomogenitäten eine örtlich unterschiedliche Ätzung auf. Dies führt zu einer Aufrauhung der geätzten Folie und der inneren Wandungen der geätzten Teilchenspuren, sowie zu den bereits im Vorstehenden geschilderten Nachteilen.

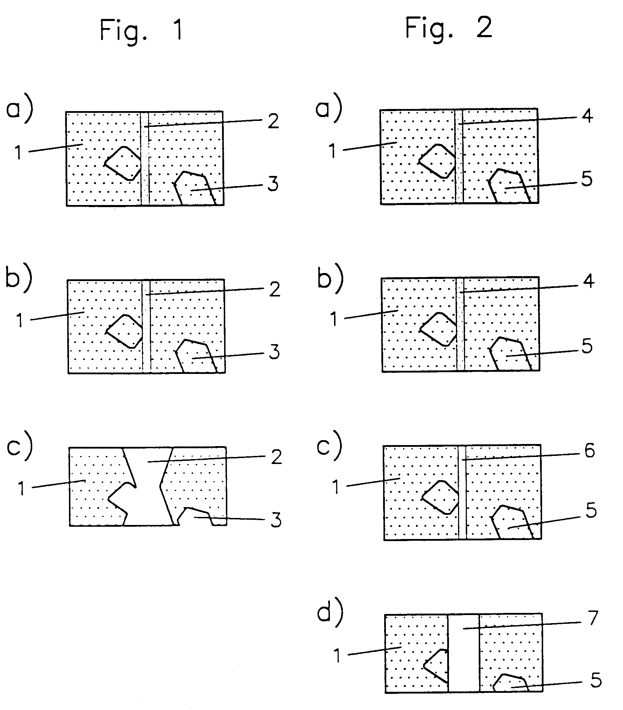

Das vorstehende Verfahren zum Stand der Technik wird im Beschreibungsteil der vorliegenden Anmeldung anhand der Fig.1 noch weiter erläutert.

Ausgehend von diesem Stand der Technik hat die vorliegende Erfindung zur Aufgabe, ein Verfahren zur Erzeugung von Mikrostrukturen anzugeben, welches die genannten Nachteile nicht mehr aufweist und mit welchem sich optimalere Strukturen erzeugen lassen. Insbesondere soll das Verfahren die Herstellung von Mikrostrukturen ermöglichen, deren Geometrie vorbestimmbar ist und deren Poren z.B gleichmäßigere Durchmesser besitzen und/oder die möglichst glatte und parallele Wände aufweisen.

Zur Lösung dieser Aufgabe schlägt nun die vorliegende Erfindung bei einem Verfahren der eingangs beschriebenen Art den Verfahrensschritt vor, der im kennzeichnenden Teil angeführt ist. Weitere vorteilhafte Verfahrenschritte sind in den Merkmalen der Unteransprüche zu sehen.

Das erfindungsgemäße Verfahren basiert auf der neuen und überraschenden Erkenntnis, daß die Selektivität bei einer Ätzung in wässriger Lösung vom pH-Wert derselben abhängt. Durch entsprechende Steuerung desselben, vorzugsweise durch stufenweises Variieren, lassen sich nun Strukturen erzeugen, deren Geometrie exakt vorbestimmbar ist. Damit lassen sich z.B. genau parallelwandige Kanäle erzielen. Auch kegelige Mikroporen, sowie solche in Form eines gefaßten Hohlzylinders lassen sich herstellen. Nach dem geometriebestimmenden ersten Ätzschritten kann durch geeignete Wahl des pH-Wertes eine Verkürzung für den porenvergrößerenden Ätzprozeß erzielt werden. Der Materialdurchsatz im Ätzbad kann dadurch erhöht werden. Das Verfahren erzeugt bei den Strukturen glatte Materialoberflächen sowie glatte Lochwände. Die Kegeldurchmesser bei kegeligen Strukturen können dabei durch Wahl der Selektivität über den pH-Wert eingestellt werden, da die Erhöhung der Materialätzrate immer mit einer Verkleinerung der Selektivität des Ätzprozeßes in den latenten Teilchenspuren verbunden ist. Dadurch vergrößert sich dann der Ätzkegel und es entstehen kegelförmige Ätzporen. Dabei ist die getrennte Optimierung von Selektivität und Glättung bei der Herstellung von Mikrostrukturen mit Hilfe der Spurätztechnik neu und besonders vorteilhaft. Das Verfahren ist besonders gut geeignet für isolierende Materialien, wie vorzugsweise Polyimid.

Weitere Einzelheiten des neuen Verfahrens werden im folgenden und anhand der Figuren 1 bis 7 näher erläutert. Es zeigen:
Die Fig.1 die Schritte eines Verfahrens nach dem Stand der Technik,
die Fig.2 die Verfahrensschritte des erfindungsgemäßen Verfahrens,
die Fig.3 die Abhängigkeit der Materalätzrate V_{B} vom pH-Wert der Ätzflüssigkeit,
die Fig.4 die Abhängigkeit der Spurätzrate V_{T} vom pH-Wert der Ätzflüssigkeit,
die Fig.5 erzeugbare Formen der Mikrokanäle,
die Figuren 6 und 7 jeweils rasterelektronenmikroskopische Aufnahmen von Mikrolöchern.

In der Fig.1 sind die Verfahrensschritte a) bis c) des eingangs erwähnten Verfahrens nach dem Stand der Technik dargestellt. Nach der Bestrahlung a) ist in der Folie 1 eine latente Teilchenspur 2 gebildet, die z.T vorhandene Inhomogenitäten 3 des Materiales berührt. Die Stufe b) zeigt die Lagerung an der Luft, wobei die latenten Teilchenspuren 2 durch Oxidationsprozesse "gereift" werden. Die Inhomogenitäten 3 bleiben unverändert. Durch die Ätzung gem. c) werden die Teilchenspuren 2 erweitert, die Inhomogenitäten 3 werden ebenfalls entfernt. Dadurch werden die Durchmesser ungleichmäßig und die Flächen bzw. Seitenwände uneben. Dieses Verfahren weist somit die eingangs erwähnten Nachteile auf.

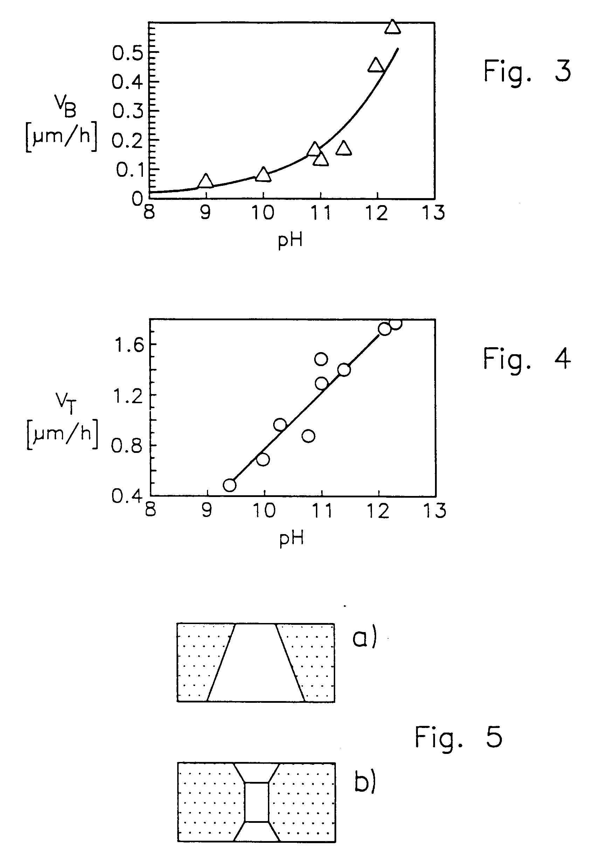

Das neue zweistufige Ätzverfahren ist in der Fig 2. anhand seiner Schritte a) bis d) erläutert:
Die Schritte a) und b) sind hier dieselben wie die bei dem in der Fig.1 beschriebenen Verfahren. Auch hier wird im Schritt a) durch Bestrahlung in der Folie 1 mit den Inhomogenitäten 5 eine latente Teilchenspur 4 erzeugt, die im Schritt b) durch Oxidationsprozeße gereift wird. Die Inhomogenitäten 5 bleiben dabei unverändert.

Basis der jetzt neu folgenden Schritte ist die bereits im Vorstehenden erwähnte neue Erkenntnis, daß die Selektivität S vom pH-Wert der wässrigen Ätzlösung abhängig. Dies ergibt sich deswegen, weil die Selektivität S der Quotient bzw. das Verhältnis der Spurätzrate V_{T} und der Materialätzrate V_{B} ist und diese ihrerseits linear bzw. exponentiell vom pH-Wert abhängen. Dieser Zusammenhang ist in den Figuren 3 und 4 dargestellt, wobei die Fig.3 die Materialätzrate V_{B} des Polyimids Kapton (Handelsmarke DuPont) mit exponentiellem Anstieg und die Fig.4 die Spurätzrate V_{T} desselben Materiales mit linearem Anstieg in Abhängigkeit des pH-Wertes der Ätzflüssigkeit zeigt. Beide Ätzraten überlagern sich. Daraus ist nun leicht ersichtlich, daß durch ein stufenweises Variieren des pH-Wertes der Ätzflüssigkeit die Ätzraten vielfältig beeinflusst werden können. Je nach der jeweiligen Ätzrate ergibt sich dann eine ganz bestimmte gewünschte Form der auszuätzenden Struktur.

In der Fig.2 ist dieser Vorgang in zwei Stufen als Beispiel für die Herstellung parallelwandiger Poren dargestellt. Die erste ist der Schritt c), eine Art selektive Vorätzung. In dieser Stufe werden jetzt kurze Bruchstücke der Molekülketten selektiv entfernt, in der dargestellten Form mit hoher Spurätzrate V_{T}, d.h die Teilchenspur 4 wird sozusagen "eng ausgeräumt". Dieses Herauslösen von Zonen in atomaren Abmessungen kann man als eine Art Sensibilisierung in den durch die Teilchen- bzw Kernspur geschädigten Materialzonen der Folie 1 bezeichnen. Eine wie dargestellt erste Stufe einer Art Vorätzung kann so eingestellt werden, daß die Inhomogenitäten 5 unverändert bleiben. Bevorzugt werden dabei Zonen bis ca 100mal Atom- bzw Moleküldurchmesser herausgelöst. Durch das Ätzmedium mit dem pH-Wert der ersten Stufe bzw des ersten gewünschten pH-Wertes mehrerer oder vieler Stufen einzelner selektiver Ätzschritte werden nur zerkleinerte Molekülbruchstücke entfernt, wobei das Medium den übrigen Festkörper nicht angreift.

Die so in der ersten Stufe vorgeätzte Teilchenspur 6 wird nun gemäß dem Schritt d) einer zweiten Ätzstufe unterzogen, in der gezeigten Darstellung einer glättenden Nachätzung. Dadurch wird die vorgeätzte Teilchenspur 6 auf den gewünschten Durchmesser 7 erweitert. Dies kann z.B durch eine starke Erhöhung der Materialätzrate V_{B} erfolgen (z.B pH-Werte über 10). Die Inhomogenitäten 5 werden dabei gleichmäßig mit abgetragen. Der Übergang zwischen den beiden hier dargestellten Stufen c) und d) kann z.B. durch eine diskontinuierliche Änderung des pH-Wertes in derselben Ätzflüssigkeit oder durch verschiedene Ätzflüssigkeiten mit verschiedenen pH-Werten erfolgen.

In den Figuren 3 und 4 ist, wie bereits erwähnt, die Abhängigkeit der Materialätzraten V_{B} und V_{T} in µm/h eines Polyimids vom Typ Kapton (Handelsmarke DuPont) vorn pH-Wert der Ätzflüssigkeit graphisch dargestellt. Mit steigendem pH-Wert steigt gern. der Fig.3 die Materialätzrate V_{B} exponentiell sehr stark an, d.h. es würden breite Kegel entstehen. Da beide Ätzraten V_{B} und V_{T} immer überlagert sind, entstehen mit fallendem pH-Wert spitze, hohe Kegel. Danach läßt sich die Selektivität des Ätzmediums zur Erzeugung der gewünschten Struktur durch Wahl des pH-Wertes genau einstellen.

Die Stufen c) und d) des neuen mehrstufigen Ätzverfahrens mit getrennter Optimierung von Selektivität und Abtragung können auf verschiedene Art verwirklicht werden:
Durch aufeinanderfolgende Einstellung des pH-Wertes desselben Ätzmediums oder durch aufeinanderfolgenden Einsatz von Ätzmedien unterschiedlicher Selektivität, z.B. durch Vorätzung in der Nähe des Neutralpunktes (pH = 8) und Nachätzung mit einem Wert fern dem Neutralpunkt (pH = 12), wobei die Einstellung und Aufrechterhaltung des gewünschten Wertes durch Zugabe eines Puffers erfolgt. Die Einstellung und Aufrechterhaltung kann auch mittels fortlaufender Kontrolle durch ein rückgeregeltes Dosiersystem erzielt werden.

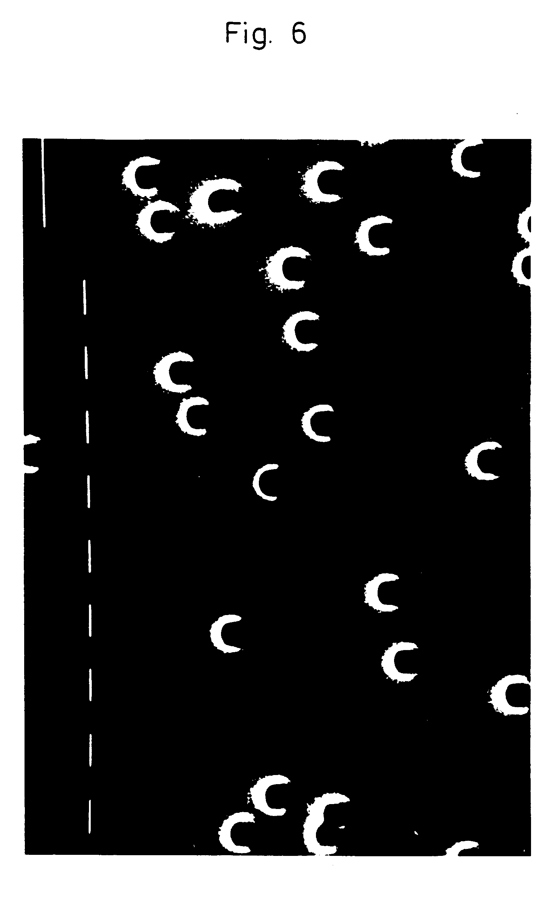

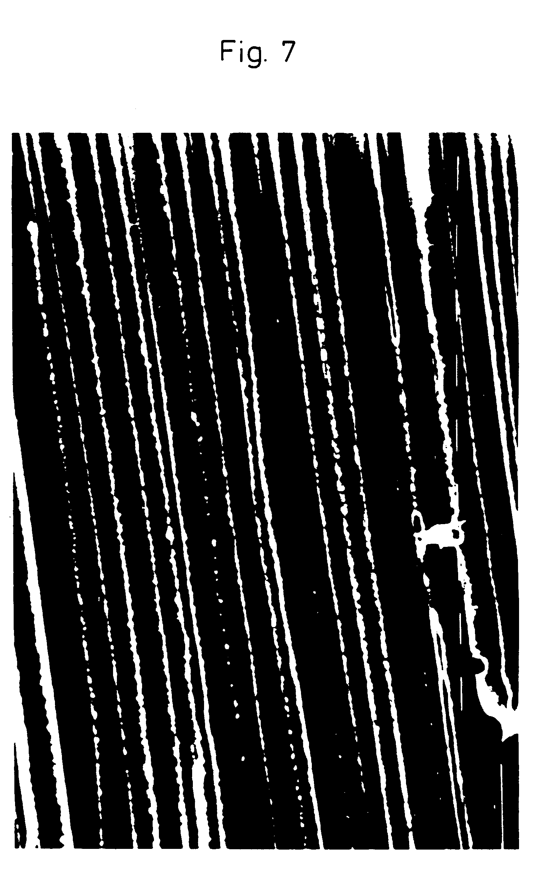

In der Fig.6 ist die Oberfläche, in der Fig.7 die Bruchfläche eines solchen Kapton-Filters mikroskopisch vergrößert dargestellt, der nach dem folgenden Ausführungsbeispiel hergestellt wurde. Die Lochdurchmesser schwanken nur geringfügig, die Spurkanäle sind nahezu parallelwandig:
Eine 50 µm dicke Polymidfolie (Kapton) wude mit 11 MeV/Nukleon Gold-Ionen bei einer Flächenbelegungsdichte von 10⁷ Ionen/cm² bestrahlt. Die bestrahlte Folie wurde mehrere Tage an Luft gelagert und in einer auf pH = 9 gepufferten Chlorbleichlauge während drei Stunden bei 60° C vorgeätzt. Dabei entstanden parallelwandige, vorgeätzte Zonen von 0,2µm Durchmesser. Die vorgeätzte Zone wurde anschließend in einer ungepufferten Chlorbleichlauge bei pH = 12,5 und 50° C nachgeätzt. Dabei wurden die vorgeätzten Kanäle in 1,5h auf 1 µm Lochdurchmesser aufgeätzt. Die enstandene Porenstruktur ist in den Figuren 6 und 7 vergrößert dargestellt.

In der Fig.5 sind zwei weitere, spezielle Grundformen von Poren gezeigt, welche sich mit dem neuen Verfahren erzeugen lassen. Dabei zeigt a) einen Kegelstumpf durch einseitige Ätzung von unten und b) einen gefasten Hohlzylinder. Dieser wird durch Vorätzung bei geringer und Nachätzung bei hoher Selektivität erzeugt. Es versteht sich, daß mit dem erfindungsgemässen Verfahren durch beliebige Variation und Kombination der Ätzschritte noch viele weitere Strukturen herstellbar sind. Ebenso ist neben den stufigen Schritten auch eine kontinuierliche Änderung der Ätzflüssigkeit möglich.

## Patentansprüche

1. Verfahren zum Erzeugen von Mikrostrukturen wie Mikrolöchern oder -kanälen in isolierenden Festkörpern, vorzugsweise aus Polyimid durch Bestrahlen des Festkörpers mit Ionen vorbestimmter Kernladungszahl, Dichte und Energie, mit anschließendem Reifen der Teilchenspuren durch Oxydationsprozesse und darauf folgendem Ätzen der gereiften Teilchenspuren in wäßriger Ätzlösung, dadurch gekennzeichnet, daß der pH-Wert der Lösung während der Ätzung über mehrere Werte variiert wird.

2. Verfahren nach Anspruch 1, dadurch gekennzeichnet, daß die Variierung in stufenweise abgegrenzten Werten erfolgt.

3. Verfahren nach Anspruch 1, dadurch gekennzeichnet, daß die Variierung kontinuierlich erfolgt.

4. Verfahren nach Anspruch 1, dadurch gekennzeichnet, daß zunächst in der Nähe des Neutralpunktes mit etwa pH = 8 und dann fern dem Neutralpunkt mit etwa pH = 12 geätzt wird.

5. Verfahren nach Anspruch 2, dadurch gekennzeichnet, daß die Einstellung und Aufrechterhaltung des pH-Wertes der Stufen durch Zugabe eines Puffers in die Ätzflüssigkeit erfolgt.

6. Verfahren nach Anspruch 1, 2 oder 3, dadurch gekennzeichnet, daß die Einstellung und Aufrechterhaltung des pH-Wertes der Ätzflüssigkeit durch fortlaufende Kontrolle durch ein rückgeregeltes Dosiersystem erfolgt.

## Claims

1. Method of producing microstructures such as microslots or channels in insulating solids, preferably formed from polyimide by irradiating the solid with ions of a predetermined nuclear charge number, density and energy, with a subsequent maturing of the particle tracks by oxidation processes followed by etching of the matured particle tracks in an aqueous etching solution, characterised in that the pH value of the solution is varied over a plurality of values during the etching.

2. Method according to claim 1, characterised in that the variation is effected in stepwisely defined values.

3. Method according to claim 1, characterised in that the variation is effected continuously.

4. Method according to claim 1, characterised in that etching is effected initially in the vicinity of the neutral point with a pH of 8, for example, and then remote from the neutral point with a pH of 12, for example.

5. Method according to claim 2, characterised in that the setting and maintaining of the pH value of the steps are effected by adding a buffer in the etching fluid.

6. Method according to claim 1, 2 or 3, characterised in that the setting and maintaining of the pH value of the etching fluid are effected by continuous monitoring using a retrogressively regulated dosing system.

## Revendications

1. Procédé pour former les microstructures telles que des microtrous, ou des microcanaux dans des corps solides isolants, de préférence en polyimide, par irradiation du corps solide avec des ions ayant un numéro aotmique, une densité et une énergie déterminés, et une maturation consécutive des traces de particules par des procédés d'oxydation suivis d'une attaque des traces des particules ayant mûris, dans une solution aqueuse d'attaque, caractérisé en ce qu'on modifie la valeur de pH de la solution pendant l'attaque pour la faire passer par plusieurs valeurs.

2. Procédé selon la revendication 1, caractérisé en ce que la variation se fait par étapes suivant des valeurs délimitées.

3. Procédé selon la revendication 1, caractérisé en ce que la variation est continue.

4. Procédé selon la revendication 1, caractérisé en ce qu'on procède à une attaque chimique, tout d'abord à proximité du point neutre avec une valeur pH = 8, puis, loin du point neutre avec environ pH = 12.

5. Procédé selon la revendication 2, caractérisé en ce qu'on règle et on maintient la valeur pH des étapes par adjonction d'un agent tampon au liquide d'attaque.

6. Procédé selon les revendications 1, 2 ou 3, caractérisé en ce qu'on règle et on maintient la valeur pH du liquide d'attaque par un contrôle continu au moyen d'un système de dosage à régulation par réaction.
